# EUROPEAN PATENT APPLICATION

(11) **EP 3 941 176 A1**
(43) Date of publication of application: **19.01.2022**
(21) Application number: 19918681.8
(22) Date of filing: 14.03.2019
(51) Int. Cl.: H05K 13/08, H05K 13/04

(54) **OBJECT DETERMINATION METHOD AND OBJECT DETERMINATION DEVICE**

(71) Applicant: FUJI Corporation, Chiryu-shi, Aichi 472-8686 (JP)
(72) Inventor: NISHIDA, Kenshiro, Chiryu-shi, Aichi 472-8686 (JP); KITO, Shuichiro, Chiryu-shi, Aichi 472-8686 (JP); ONO, Keiichi, Chiryu-shi, Aichi 472-8686 (JP)
(74) Representative: Grünecker Patent- und Rechtsanwälte PartG mbB
(86) International application number: PCT/JP2019/010535
(87) International publication number: WO 2020/183698

(57) **Abstract**

An object of the present disclosure is to enable determination as to whether a recognition image included in a captured image is a target image corresponding to an object.

In the present object determination method, it is determined whether a recognition image is a target image corresponding to an object based on a comparison result between a brightness of at least one point located inside the recognition image included in a captured image and a brightness of an edge of the recognition image. For example, in a case where the object is brighter than a circuit board, at least one point located inside the target image is brighter than the brightness of the edge of the target image. On the other hand, in a case where at least one point located inside the recognition image is darker than the brightness of the edge of the recognition image, it is possible to determine that the recognition image is not the target image.

## Description

### Technical Field

The present disclosure relates to an object determination method and an object determination device for determining whether a recognized one is an object.

### Background Art

Patent Literature 1 describes a center position acquiring method in which, for a recognition image included in a captured image imaged by an imaging device, an average value of brightness of multiple points located in a first area including a temporary center point inside the recognition image and an average value of brightness of multiple points located in a second area in a periphery of the first area are acquired, and in a case where the average value of the brightness of the first area is higher than a first threshold value and the average value of the brightness of the second area is equal to or less than a second threshold value which is smaller than the first threshold value, the temporary center point is set as a true center point. The first threshold value and the second threshold value are fixed values, and are acquired and stored in advance.

### Patent Literature

Patent Literature 1: JP-A-2007-273519

### Summary of the Invention

### Technical Problem

An object of the present disclosure is to enable determination as to whether a recognition image included in a captured image is a target image corresponding to an object.

### Solution to Problem and Advantageous Effect of the Invention

In the present object determination method, it is determined whether a recognition image is a target image corresponding to an object based on a comparison result between brightness of at least one point located inside the recognition image included in a captured image and brightness of an edge of the recognition image. For example, in a case where the object is brighter than a circuit board, at least one point located inside the target image is brighter than the brightness of the edge of the target image. Therefore, in a case where at least one point located inside the recognition image is darker than the brightness of the edge of the recognition image, it is possible to determine that the recognition image is not the target image, whereas in a case where at least one point located inside the recognition image is brighter than the brightness of the edge, it is possible to determine that the recognition image is the target image.

The inside of the recognition image may be a portion surrounded by an external line defining the recognition image, that is, by the edge. The same applies to the target image. In addition, although the recognition image may be a ghost image, in this case, it is determined that a recognized one corresponding to the recognition image does not actually exist and the recognition image is not the target image. In addition, the recognized one and the object can be a pattern formed on the circuit board, a component mounted on the circuit board, or the like. Further, the object can be a fiducial mark formed on the circuit board or an appropriate component to be mounted on the circuit board. The appropriate component is an appropriate product that is a component determined in advance to be mounted on the position of the circuit board, and a component that is the appropriate product and mounted in a correct state may refer to the object. The correct state means, for example, a state where a top surface is located on an upper side instead of a bottom surface being located on the upper side.

### Brief Description of Drawings

Fig. 1 illustrates a mounter to which an object determination device according to a first embodiment of the present disclosure is connected.
Fig. 2 is a side view illustrating the mounter.
Fig. 3 is an enlarged side view (partial sectional view) illustrating a main portion of the mounter.
Fig. 4 is a side view illustrating a vertical lighting device of the mounter.
Fig. 5 is a diagram conceptually illustrating a control device for controlling the mounter and a periphery of the object determination device.
Fig. 6A is a plan view illustrating the circuit board. Fig. 6B is image A of area R of the circuit board.
Fig. 7A is a mark image included in image A. Fig. 7B is a graph illustrating a brightness distribution inside the mark image.
Fig. 8A is a plan view of a recognition image included in image A. Fig. 8B is a graph illustrating a brightness distribution inside the recognition image.
Fig. 9 is a graph illustrating another example of the brightness distribution of the mark image.
Fig. 10 is a graph illustrating another example of the brightness distribution of the recognition image.
Fig. 11 is a flowchart indicating a mark image determination program stored in a storage section of the object determination device.
Fig. 12 is a flowchart indicating another mark image determination program stored in the storage section of the object determination device.
Fig. 13 is a view conceptually illustrating a distribution of specific points.
Fig. 14 is a flowchart indicating another mark image determination program stored in the storage section of the object determination device.
Figs. 15A to 15C are views illustrating recognition images determined by an object determination device according to a second embodiment of the present disclosure.
Fig. 16 is a flowchart indicating the target image determination program stored in the storage section of the object determination device.
Fig. 17 is a diagram conceptually illustrating a periphery of an object determination device according to a third embodiment of the present disclosure.

### Description of Embodiments

An object determination device and a mounter to which the object determination device is connected according to an embodiment of the present disclosure will be described in detail with reference to the drawings. In the object determination device, an object determination method that is an embodiment of the present disclosure is implemented.

### [First Embodiment]

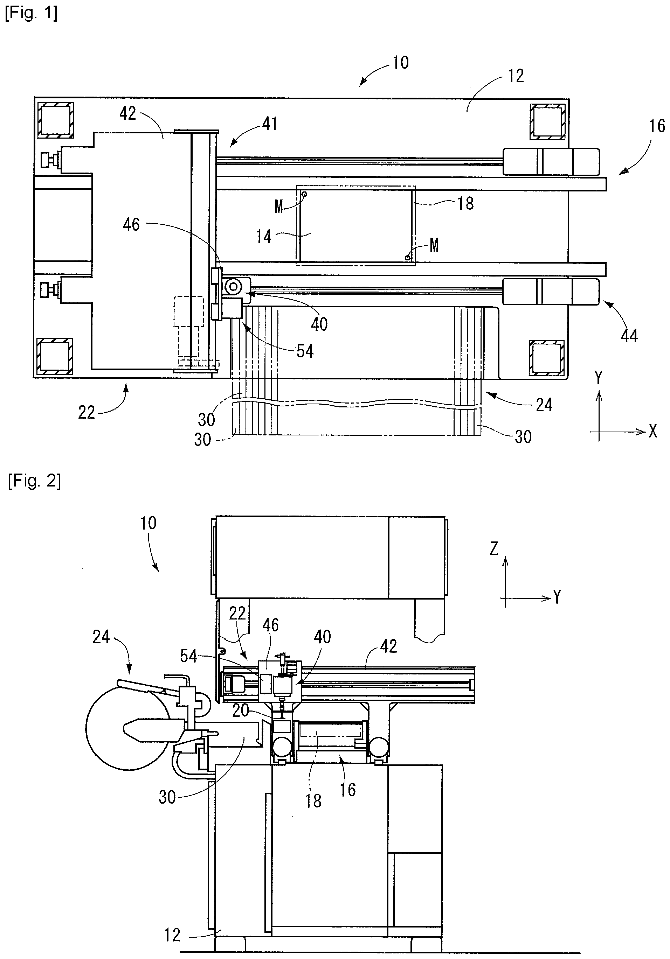

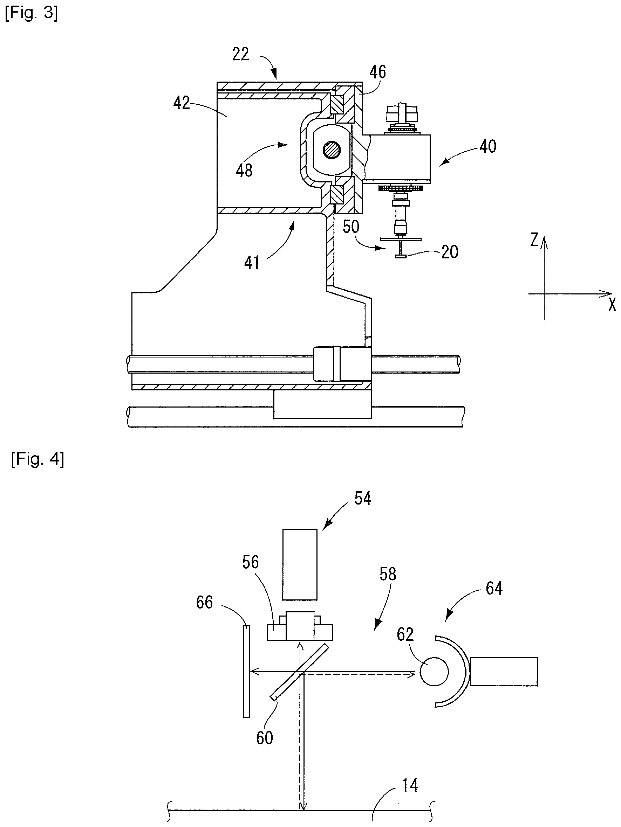

In Fig. 1, reference symbol 12 represents a base serving as a main body of mounter 10. Board conveyance device 16 for conveying circuit board (hereinafter, abbreviated as a board) 14 in X direction, board holding device 18 for holding board 14, component mounting device 22 for mounting electronic circuit component 20 (see Fig. 3; hereinafter, abbreviated as component 20) on board 14, component supply device 24 for supplying component 20 to component mounting device 22, and the like are provided on base 12. Fiducial mark M is provided on board 14. A width direction of board 14 is defined as Y direction and an up-down direction is defined as Z direction. X direction, Y direction, and Z direction are orthogonal to each other.

Component supply device 24 may include, for example, multiple tape feeders 30.

Component mounting device 22 conveys component 20 with component holding head 40 illustrated in Fig. 3 and mounts component 20 on the upper surface of board 14. As illustrated in Fig. 1, component mounting device 22 includes head moving device 41 that moves component holding head 40 to an arbitrary position within a horizontal plane that is a plane parallel to XY-coordinate plane, and head moving device 41 includes X slide 42, X slide moving device 44 (see Fig. 1), Y slide 46, Y slide moving device 48, and the like. X slide moving device 44 moves X slide 42 in X direction. Y slide 46 is provided on X slide 42 and Y slide moving device 48 relatively moves Y slide 46 in Y direction on X slide 42.

Component holding head 40, fiducial mark camera 54 (see Fig. 1), annular lighting device 56 (see Fig. 4), and vertical lighting device 58 are integrally movably attached to Y slide 46. Component holding head 40 includes, for example, suction nozzle 50. In suction nozzle 50, component 20 is picked up by a negative pressure, and is mounted on board 14 by releasing the negative pressure.

Fiducial mark camera 54 is an imaging device for imaging fiducial mark M or the like formed on board 14 and in the present embodiment, is configured of a CCD camera. As illustrated in Fig. 4, annular lighting device 56 irradiates light around fiducial mark camera 54 to light fiducial mark M on board 14 and a portion of a periphery thereof. Vertical lighting device 58 includes half mirror 60, light source 64 including halogen lamp 62, and the like. Half mirror 60 is provided below fiducial mark camera 54 so as to be inclined by 45 degrees with respect to an optical axis of fiducial mark camera 54. Half mirror 60 is irradiated with light in the horizontal direction from light source 64 and reflects the light vertically downward. Reference symbol 66 represents non-reflective paper. Non-reflective paper 66 absorbs the light transmitted through half mirror 60.

When fiducial mark camera 54 images board 14, either annular lighting device 56 or vertical lighting device 58 is selectively used.

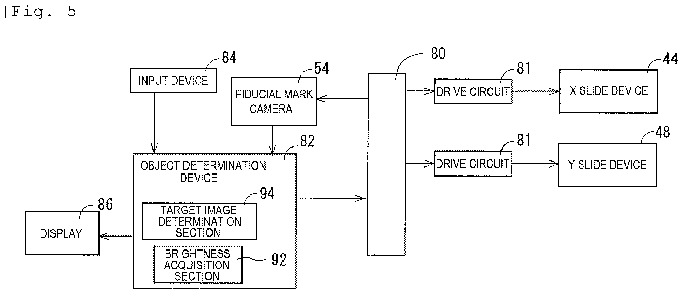

Mounter 10 includes mounting machine control section 80 illustrated in Fig. 5. Mounting machine control section 80 is configured mainly of a computer and X slide moving device 44, Y slide moving device 48, and the like are connected to an input and output section (not illustrated) via drive circuit 81, as well as object determination device 82, fiducial mark camera 54, and the like are connected thereto.

Object determination device 82 is configured mainly of a computer and includes brightness acquisition section 92 for acquiring brightness of multiple points included in a captured image imaged by fiducial mark camera 54 and target image determination section 94 for determining whether each of at least one of one or more recognition images included in the captured image is a target image. Fiducial mark camera 54, input device 84, display 86, and the like are connected to the input and output section (not illustrated) of object determination device 82.

In mounter 10 configured as described above, mounting work of component 20 on board 14 is performed. Board 14 is conveyed to a predetermined work position by board conveyance device 16, is positioned, and held by board holding device 18. Fiducial mark camera 54 is positioned at a predetermined fiducial mark imaging position to image fiducial mark M or the like provided on board 14. The position of fiducial mark M is acquired by image processing of the captured image and a positional error of board 14 is acquired. Thereafter, component holding head 40 receives component 20 from feeder 30, is moved to a predetermined position on board 14, that is, a position corrected based on the positional error, and mounts component 20.

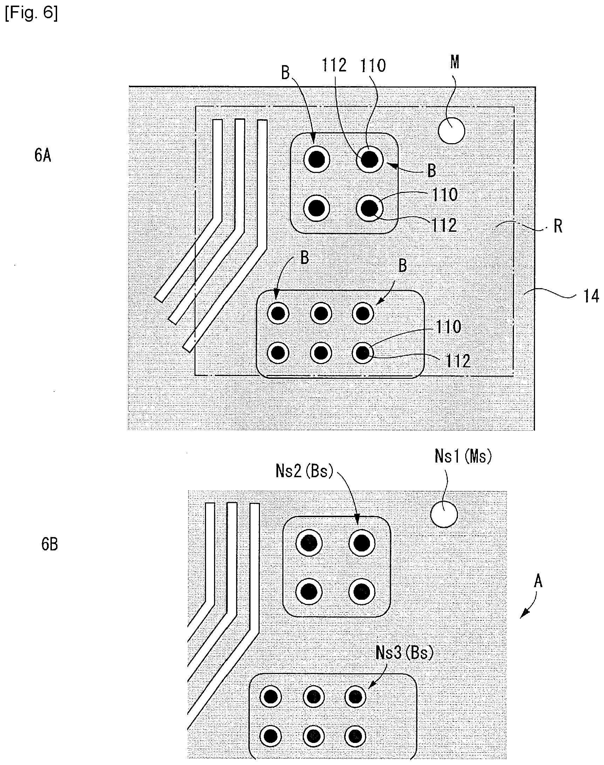

The image processing of the captured image obtained by the imaging of fiducial mark camera 54 is performed in object determination device 82. As illustrated in Fig. 6A, set area R including fiducial mark M of board 14 is imaged by fiducial mark camera 54, and thereby captured image A is acquired as illustrated in Fig. 6B. However, for example, since recognized ones such as fiducial mark M, lead wire insertion portion B, and wiring are formed on board 14, captured image A includes recognition images Ns1, Ns2, Ns3, ... , and the like which are multiple recognizable images. Hereinafter, in a case where it is not necessary to distinguish multiple recognition images Ns1, Ns2, Ns3, ... , and the like from each other, recognition image Ns may be simply referred to as a generic term.

Accordingly, in the present embodiment, in object determination device 82, multiple recognition images Ns are acquired by the image processing for captured image A, and it is determined whether each of multiple recognition images Ns is mark image Ms that is the target image. Therefore, mark image Ms is specified from multiple recognition images Ns, the position of fiducial mark M is acquired, and a positional error of board 14 is acquired.

Specifically, for each of multiple recognition images Ns included in captured image A, edge E is first acquired and a size (for example, a length of a diameter) of recognition image Ns is acquired. Then, the length of the diameter of each of multiple recognition images Ns and the length of the diameter of known mark image Ms are compared and, for example, a candidate image in which an absolute value of the difference is smaller than the set value is acquired. In addition, brightness T of edge E is acquired and stored for each recognition image Ns.

Next, for recognition image Ns that is the candidate image, brightness T(i) of multiple points P(i) located inside the candidate image is acquired, and each is compared with brightness T of edge E. Based on the comparison result, it is determined whether each recognition image Ns, which is the candidate image, is mark image Ms.

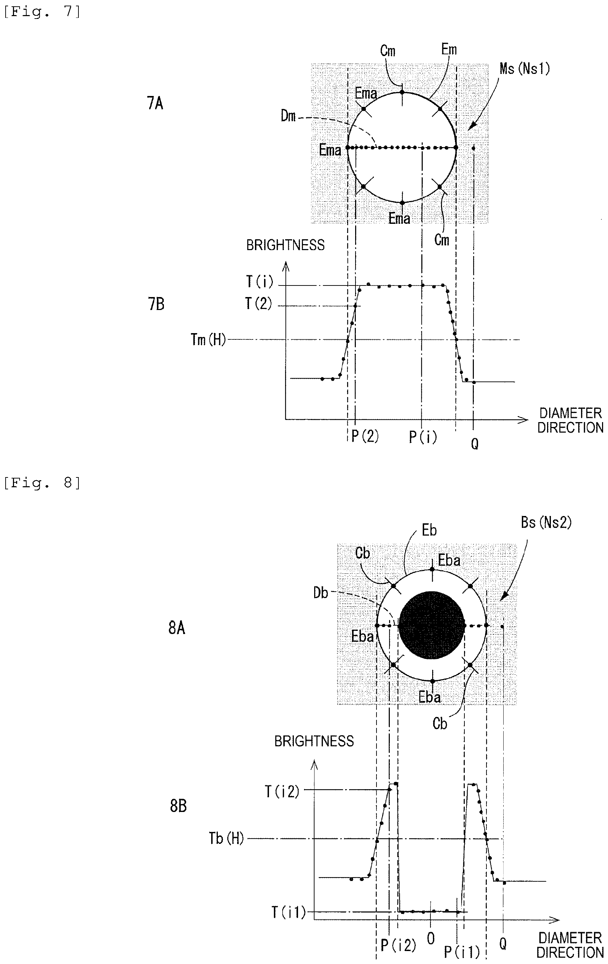

For example, in a case where a top surface of board 14 forms substantially green and fiducial mark M forms substantially white, fiducial mark M is whiter and brighter than board 14. As illustrated in Figs. 7A and 7B, the brightness of multiple points P(i), i = 1, 2, ... located inside mark image Ms, which is one of the recognition images, is larger than the brightness of point Q on the image indicating board 14. In other words, each brightness T(i) of multiple points P(i) located inside mark image Ms is larger than brightness Tm of edge Em that is a boundary between mark image Ms and the image indicating board 14.

Brightness Tm of edge Em is determined based on brightness Tma of multiple edge points Ema which are points of which a gradient of change in brightness of each of multiple seek lines Cm provided on mark image Ms substantially orthogonal to the edge is maximum. For example, a value obtained by statistically processing brightness Tma of each of multiple edge points Ema, for example, an average value can be set as brightness Tm of edge Em. The brightness of a point on captured image A is acquired by brightness acquisition section 92.

In addition, it is desirable that multiple points P(i) located inside mark image Ms are provided substantially along diameter Dm of mark image Ms. This is because diameter Dm passes through a central portion that is a characteristic section of mark image Ms.

As illustrated in Fig. 6A, lead wire insertion portion B includes land 110 and hole (may also be referred to as a through-hole) 112, land 110 is brighter than board 14, and hole 112 is darker than board 14. Therefore, as illustrated in Figs. 8A and 8B, the brightness of point P(i1) located at the central portion (portion including the center point of insertion portion image Bs) among multiple points inside insertion portion image Bs that is the recognition image indicating lead wire insertion portion B is smaller than brightness Tb of edge Eb of insertion portion image Bs, but the brightness of point P(i2) located at a periphery portion is larger than brightness Tb of edge Eb. Brightness Tb of edge Eb is similarly acquired based on brightness Tba of multiple edge points Eba acquired based on the change in brightness along multiple seek lines Cb provided in insertion portion image Bs.

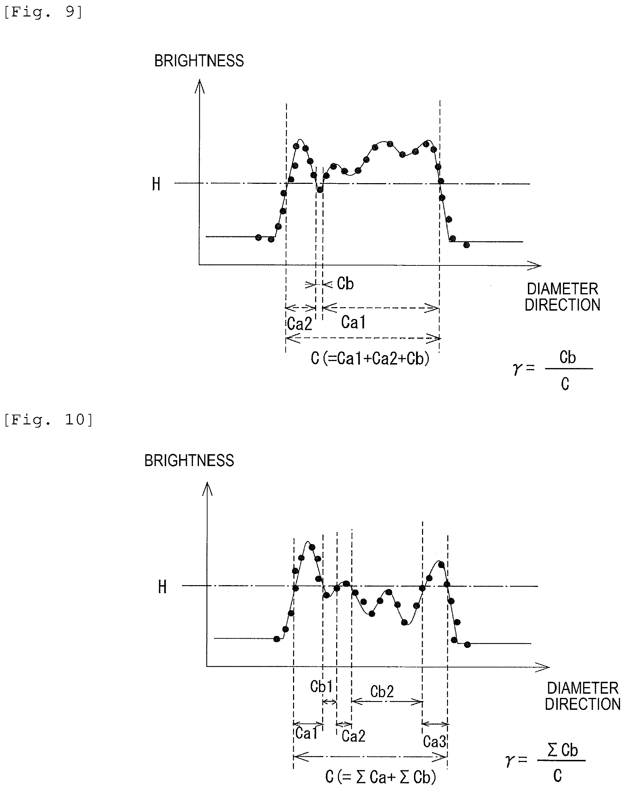

However, as illustrated in Fig. 9, among points P(i) located inside recognition image Ns, even if there is a point of which brightness T(i) is smaller than brightness T (= threshold value H) of edge E, in a case where the number of such points is small, for example, in a case where ratio y of the number of the low brightness points of which brightness T(i) is lower than threshold value H to the number of total points P(i) is equal to or less than set ratio yth, it is possible to determine that recognition image Ns is mark image Ms. For example, it is considered that a low brightness point exists due to scratches or foreign matter adhering to the inside of fiducial mark M.

On the other hand, as illustrated in Fig. 10, in a case where ratio y of the low brightness point located inside recognition image Ns is higher than set ratio yth, it is determined that recognized one Ns is likely to have a hole, and it is determined that recognition image Ns is not mark image Ms.

As described above, in the present embodiment, brightness T(i) for each of multiple points P(i) located substantially along the diameter inside each of recognition images Ns that are candidate images is acquired by brightness acquisition section 92, each brightness T(i) is compared with brightness T of edge E of recognition image Ns, and it is determined whether recognition image Ns is mark image Ms based on the comparison result. Specifically, in each of recognition images Ns, brightness T of edge E is set as the threshold value and in a case where the ratio of the number of points P(i) of which brightness T(i) is equal to or less than the threshold value to the number of multiple points P(i) inside thereof is equal to or less than the set ratio, it is determined that recognition image Ns is mark image Ms.

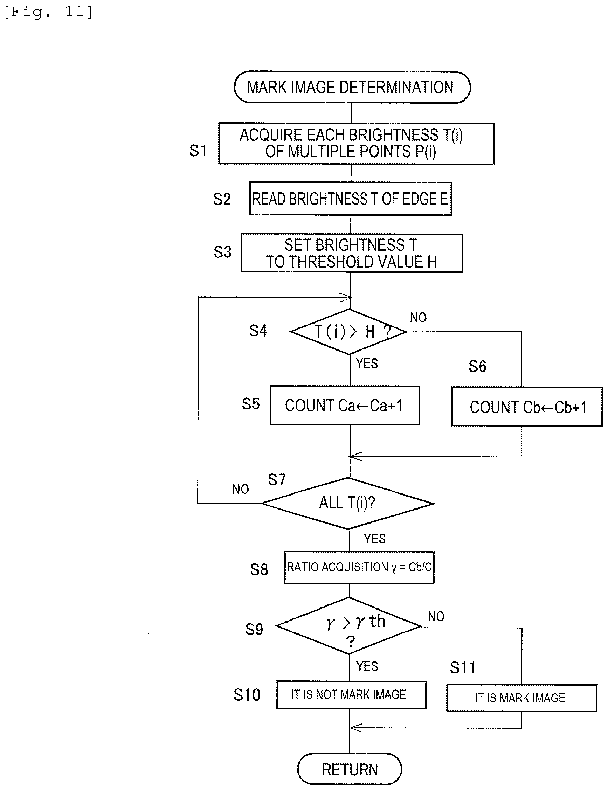

Whether each of recognition images Ns is mark image Ms is determined by execution of a mark image determination program indicated in a flowchart of Fig. 11. In Step 1 (hereinafter, abbreviated as S1; the same applies to other steps), for each of recognition images Ns, multiple points P(i) are set substantially along the diameter and brightness T(i) at each of multiple points P(i) is acquired. In S2, brightness T of edge E of recognition image Ns is read and in S3, brightness T of edge E is set to threshold value H.

In S4, it is determined whether each brightness T(i) of multiple points P(i) located inside recognition image Ns is larger than threshold value H. For example, number Ca of high brightness points P of which brightness T(i) is larger than threshold value H and number Cb of low brightness points P of which brightness T(i) is equal to or less than threshold value H are counted in S5 and S6, respectively. In S7, it is determined whether the comparison with threshold value H is completed for all of multiple points P(i). In a case where the determination result is NO, S4 to S7 are repeatedly executed. In a case where the determination result is YES, ratio y (= Cb/C) of number Cb of low brightness points to number C (= Ca + Cb) of total points is acquired in S8 and it is determined whether ratio y is larger than set ratio yth in S9.

In a case where the determination in S9 is YES, it is determined that recognition image Ns is not mark image Ms in S10, whereas in a case where the determination result is NO, it is determined that recognition image Ns is mark image Ms in S11.

For example, in a case where recognition images Ns1 and Ns2 are set as candidate images, in recognition image Ns1, as illustrated in Figs. 7A and 7B, each brightness T(i) of multiple points P(i) set substantially along diameter Dm is larger than brightness Tm of edge Em. Therefore, ratio y of the number of low brightness points to the number of total points is equal to or less than set ratio yth and it is determined that recognition image Ns1 is mark image Ms.

On the other hand, in recognition image Ns2, as illustrated in Figs. 8A and 8B, multiple points P(i) are set substantially along diameter Db, each brightness T(i) is acquired, and the brightness of multiple points P(i1) located at the central portion is smaller than brightness Tb of edge Eb. Therefore, ratio y of the number of low brightness points to the number of total points is larger than set ratio yth, and thereby it is determined that recognition image Ns2 is not mark image Ms.

As is clear from mark image Ms and recognition image Ns2, the comparison result between the brightness of point P(i) located at the central portion and brightness T of edge E among multiple points P(i) differs between mark image Ms and recognition image Ns2. Therefore, the central portion of mark image Ms is used as a characteristic section. This characteristic section can also be considered to be a characteristic section of insertion portion image Bs.

As described above, the low brightness point is set as the specific point and it is determined whether recognition image Ns is mark image Ms based on the ratio of the number of the specific points to the number of total points. Accordingly, although the sizes are substantially the same, it is possible to make insertion portion image Bs (Ns2) corresponding to lead wire insertion portion B having hole 112 difficult to be erroneously determined to be mark image Ms, mark image Ms can be satisfactorily specified from multiple recognition images Ns.

In addition, the brightness of multiple points P(i) included in recognition image Ns often changes depending on the state of lighting and brightness T of edge E is not always constant. On the other hand, in each of recognition images Ns, after brightness T of edge E is acquired and the candidate image is acquired, brightness T(i) of multiple points P(i) inside recognition image Ns, which is the candidate image, is compared with threshold value H which is brightness T of edge E. Therefore, as compared with a case where threshold value H is a fixed value, it is possible to accurately acquire whether brightness T(i) of multiple points P(i) located inside recognition image Ns is larger than brightness T of edge E.

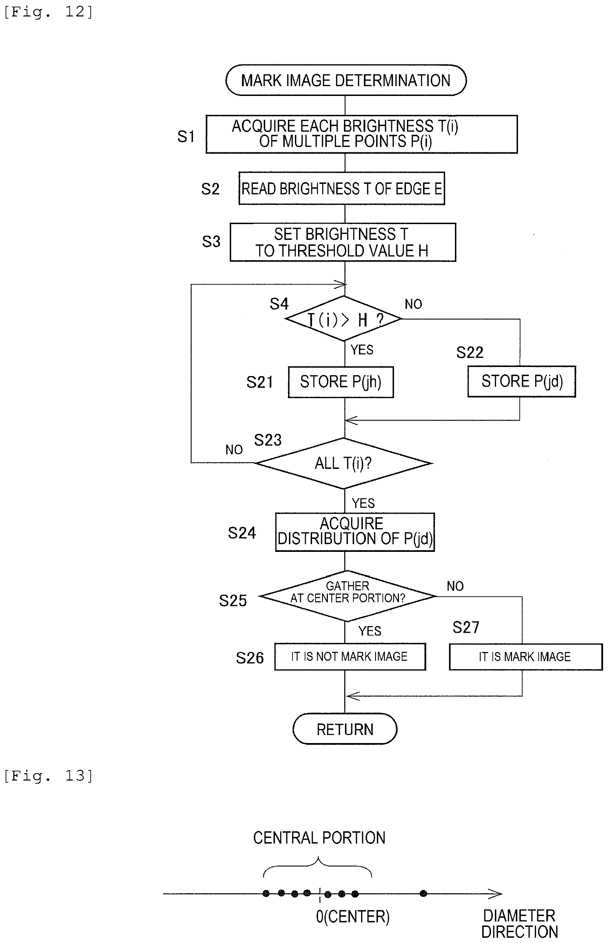

Whether recognition image Ns is mark image Ms can be determined by execution of a mark image determination program indicated in a flowchart of Fig. 12. In the present embodiment, it is determined whether it is mark image Ms based on a position of a point of which the brightness of recognition image Ns is equal to or less than threshold value H. In a program indicated in the flowchart of Fig. 12, steps in which the same execution as the program indicated in the flowchart in Fig. 11 is performed are assigned with the same step numbers, and descriptions thereof will be omitted.

In the present program, it is determined whether each brightness T(i) of multiple points P(i) located inside recognition image Ns is larger than threshold value H in S4, and high brightness point P(jh) and low brightness point P(jd) are stored, respectively in S21 and S22 based on the determination result of S4. Then, the distribution of low brightness point P(jd) is acquired in S24, and it is determined whether low brightness point P(jd) is located at the central portion (portion including center point O) of recognition image Ns in S25. In a case where the determination result is YES, it is determined in S26 that recognition image Ns is not mark image Ms, whereas in a case where the determination result is NO, it is determined in S27 that recognition image Ns is mark image Ms.

For example, in recognition image Ns1, low brightness point P(id) does not exist. On the other hand, in recognition image Ns2, as illustrated in Fig. 13, low brightness point P(id) is gathered at the central portion of recognition image Ns2. Therefore, it is determined that recognition image Ns1 is mark image Ms and it is determined that recognition image Ns2 is not mark image Ms. As described above, in the present embodiment, low brightness point P(id) is set as the specific point and it is determined whether recognition image Ns is mark image Ms based on the distribution of the specific points. Therefore, it is possible to satisfactorily determine whether recognition image Ns indicates recognized one B having hole 112 and it is difficult to erroneously determine that insertion portion image Bs is mark image Ms.

The distribution of high brightness points P(ih) can also be acquired by using the high brightness point P(ih) as a specific point. In this case, in a case where high brightness points P(ih) exist at both the central portion and the periphery portion, it is determined that the recognition image is mark image Ms, whereas in a case where high brightness points P(ih) located at the central portion are very few, it is possible to determine that the recognition image is not mark image Ms.

As described above, in the present embodiment, in object determination device 82, target image determination section 94 is configured of a portion storing the mark image determination program (or the mark image determination program indicated in the flowchart of Fig. 12) indicated in the flowchart of Fig. 11, a portion executing thereof, and the like. In the mark image determination program (or the mark image determination program indicated in the flowchart of Fig. 12) indicated in the flowchart of Fig. 11, S1 corresponds to the brightness acquisition step, and S4 and S6 (or S4 and S22) correspond to the specific point acquisition step. In addition, in the mark image determination program indicated in the flowchart of Fig. 11, S8 corresponds to the ratio acquisition step, S9 to S11 correspond to the first determination step, in the mark image determination program indicated in the flowchart of Fig. 12, S24 corresponds to the distribution acquisition step and S25 to S27 correspond to the second determination step. In addition, in the present embodiment, fiducial mark M is set as the object.

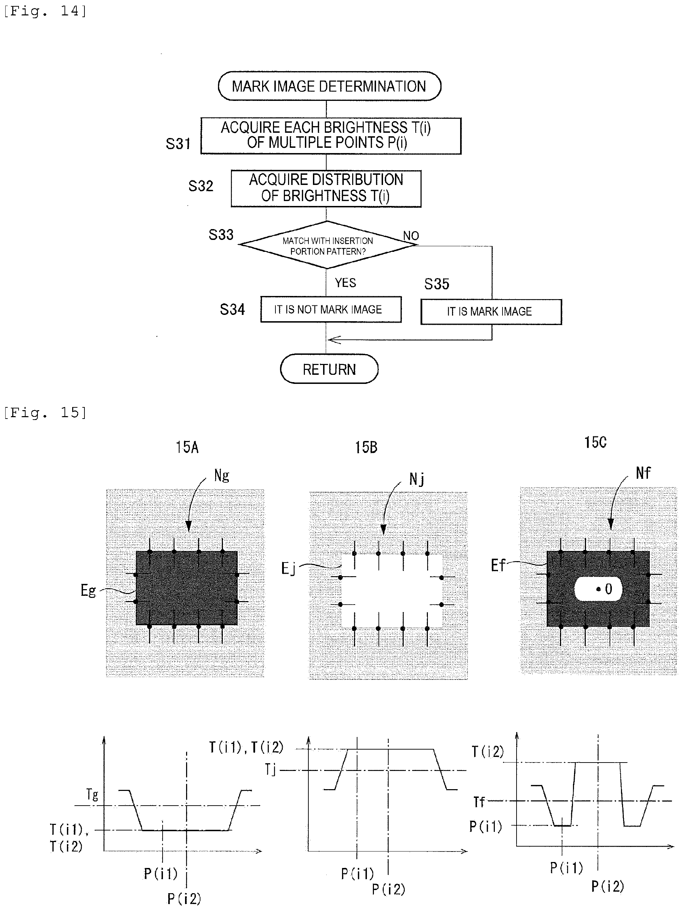

It is not indispensable to compare each brightness T(i) of multiple points P(i) located inside recognition image Ns with brightness T of edge E, it is possible to acquire the brightness distribution as illustrated in Fig. 7B and Fig. 8B, and it is possible to determine whether the brightness distribution is the same as a predetermined pattern. For example, in a case where the brightness distribution is the same pattern as the pattern (pattern indicating the brightness distribution in the insertion portion image is referred to as an insertion portion pattern; hereinafter, the same is applied) illustrated in Fig. 8B, it is possible to determine that recognition image Ns is not the mark image. An example of this case is illustrated in Fig. 14. In insertion portion image Bs, as illustrated in Fig. 8B, multiple points P(i) are provided along diameter Db, each brightness of multiple points P(i) is acquired, and as going from one end portion to the other end of diameter Db, the brightness increases and then decreases, and after that, increases and then decreases.

Each brightness T(i) of multiple points P(i) located inside recognition image Ns is acquired in S31, the brightness distribution, that is, the pattern is acquired in S32, and it is determined whether the acquired pattern is the same as the insertion portion pattern in S33. In a case where the determination result is YES, it is determined in S34 that recognition image Ns is not mark image Ms, whereas in a case where the determination result is NO, it is determined in S35 that recognition image Ns is mark image Ms. In the present embodiment, S32 corresponds to the brightness distribution acquisition step.

Although not illustrated, a portion darker than the top surface of board 14 may be used as the fiducial mark. The color of the top surface of board 14 is not limited to green and may be brighter. In the present embodiment, each brightness T(i) of multiple points P(i) located inside the mark image is smaller than brightness T of edge E of the mark image, and similarly to the case in the above embodiment, it can be determined whether each of the one or more recognition images Ns included in the captured image is the mark image.

### [Second Embodiment]

In the present embodiment, it is determined whether the component mounted on board 14 is an appropriate product (originally, meaning a component that has to be mounted at that position) and is mounted in a correct state (originally, whether a surface, which is not to be the upper surface, is the upper side) based on the comparison result between brightness T(i) of multiple points P(i) located inside the recognition image indicating the component mounted on the board included in captured image and brightness T of edge E of the recognition image.

For example, Fig. 15A illustrates appropriate image Ng that is the recognition image in a case where the appropriate product having a top surface of a color darker than board 14 is mounted in a correct state (state where the top surface is on the upper side). In Fig. 15A, brightness T(i) of multiple points P(i) located inside appropriate image Ng is smaller than brightness Tg of edge Eg of appropriate image Ng. Fig. 15B illustrates another component image Nj which is a recognition image of another component different from the appropriate product. As illustrated in Fig. 15B, brightness T(i) of multiple points P(i) located inside another component image Nj is larger than brightness Tj of edge Ej of another component image Nj. In addition, Fig. 15C illustrates back state image Nf which is a recognition image indicating a component that is the appropriate product and mounted in a front and back inverted state. As illustrated in Fig. 15C, in back state image Nf, the brightness of point P(i2) located at the central portion of multiple points P(i) is larger than brightness Tf of edge Ef of back state image Nf and the brightness of point P(i1) located at the periphery portion which is the periphery of the central portion is smaller than brightness Tf of edge Ef.

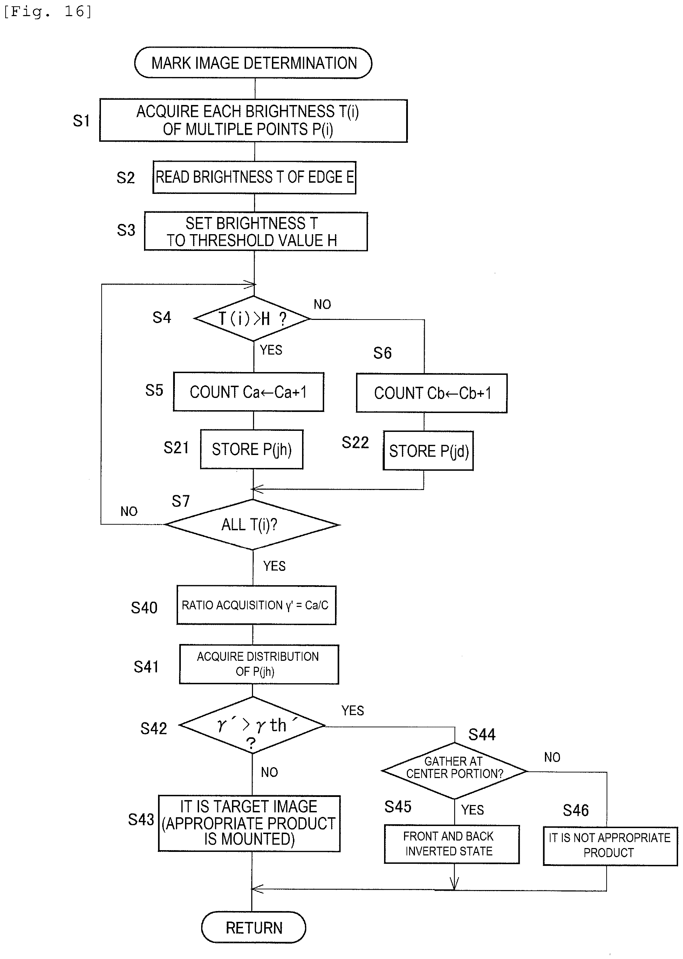

In the present embodiment, the target image determination program indicated in the flowchart of Fig. 16 is executed. In the flowchart of Fig. 16, steps in which the same execution as those in the flowcharts in Figs. 11 and 12 is performed are assigned with the same step numbers, and descriptions thereof will be omitted. In S4, each brightness T(i) of the multiple points P(i) is compared with threshold value H and in a case of being larger than threshold value H, the number of high brightness points is counted and the position is stored in S5 and S21. In a case where it is equal to or less than threshold value H, the number of low brightness points is counted and the position is stored in S6 and S22. Ratio γ' of number Ca of high brightness points that are specific points to number C of total points is acquired in S40 and the distribution of high brightness points P(jh) is acquired in S41.

Then, it is determined in S42 whether ratio y' is larger than set ratio yth'. In a case where the determination is NO, it is determined in S43 that recognition image Ns is the target image, the component corresponding to the recognition image is the appropriate product, and the component is mounted in the correct state. That is, it is determined that the recognized one is the object article. On the other hand, in a case where the determination is YES, it is determined in S44 whether the high brightness points are gathered at the central portion. In a case where the determination is YES, it is determined in S45 that the component corresponding to the recognition image is the appropriate product and is mounted in the front and back inverted state. In a case where the determination is NO, it is determined in S46 that the component corresponding to the recognition image is not the appropriate product.

As described above, the present disclosure can also be applied to the inspection method for inspecting whether the component to be mounted on board 14 is the appropriate product and whether the component is mounted in the correct state.

### [Third Embodiment]

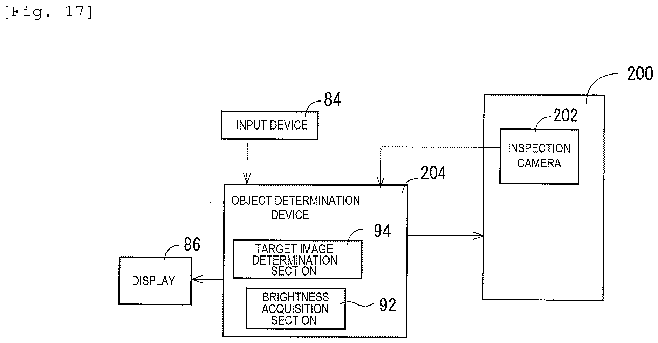

Although the determination as to whether the recognition image is the target image is performed based on captured image A acquired by fiducial mark camera 54 provided in mounter 10 has been described in the above-described first and second embodiments, as illustrated in Fig. 17, it is possible to perform the determination based on a captured image acquired by inspection camera 202 provided in inspector 200. In the present embodiment, object determination device 204 is connected to inspector 200 and inspection camera 202 is connected to object determination device 204. Also in the present embodiment, it is possible to similarly perform the determination whether the recognition image is the target image.

Although several embodiments of the present disclosure have been described above, these are mere examples, and the present disclosure can be practiced in a form where various changes and modifications are made based on the knowledge of those skilled in the art.

### Reference Signs List

10: electronic circuit component mounter, 54: fiducial mark camera, 56: lighting device, 58: vertical lighting device, 82: object determination device, 92: brightness acquisition section, 94: target image determination section

## Claims

1. An object determination method of determining whether at least one of one or more recognition images included in a captured image obtained by imaging a predetermined area on a circuit board by an imaging device is a target image that is an image indicating an object, to determine whether each recognized one corresponding to the at least one recognition image is the object, the method comprising:
determining whether the at least one recognition image is the target image based on a comparison result between a brightness of each of at least one point located inside the recognition image and a threshold value, for each of the at least one recognition image, when a brightness of an edge of the recognition image is set as the threshold value.

2. The object determination method according to claim 1, further comprising:
a brightness acquisition step of acquiring, for each of the at least one recognition image included in the captured image, a brightness of each of multiple points as the at least one point located inside the recognition image; and
a specific point acquisition step of acquiring, by comparing the brightness of each of the multiple points located inside each of the at least one recognition image acquired in the brightness acquisition step with the threshold value, a specific point inside each of the at least one recognition image, and of which the brightness is equal to or less than the threshold value or of which the brightness is larger than the threshold value.

3. The object determination method according to claim 2, further comprising:
a ratio acquisition step of acquiring a ratio of the number of the specific points acquired in the specific point acquisition step to the number of the multiple points located inside the recognition image; and
a first determination step of determining whether the recognition image is the target image based on the ratio acquired in the ratio acquisition step.

4. The object determination method according to claim 2, further comprising:
a specific point distribution acquisition step of acquiring a distribution of the specific points acquired in the specific point acquisition step; and
a second determination step of determining whether the recognition image is the target image based on a position where the specific point exists, which is acquired in the specific point distribution acquisition step.

5. The object determination method according to any one of claims 2 to 4, wherein each of the multiple points is set as a point provided so as to include at least a part of a portion of the recognition image corresponding to a characteristic section of the object.

6. The object determination method according to claim 5, wherein the characteristic section of the object is a central portion including a center point of the object.

7. The object determination method according to any one of claims 1 to 6, wherein the object is a fiducial mark formed on the circuit board.

8. The object determination method according to any one of claims 1 to 6, wherein the object is an electronic component mounted on the circuit board.

9. An object determination method of determining whether at least one of one or more recognition images included in a captured image obtained by imaging a predetermined area on a circuit board by an imaging device is a target image that is an image indicating an object, to determine whether each recognized one corresponding to the at least one recognition image is the object, the method comprising:
a brightness acquisition step of acquiring a brightness of each of multiple points included in the recognition image for each of the at least one recognition image; and
a brightness distribution acquisition step of acquiring a distribution of the brightness of each of the multiple points acquired in the brightness acquisition step,
wherein it is determined whether each of the at least one recognition image is the target image based on the brightness distribution acquired in the brightness distribution acquisition step.

10. An object determination device comprising:
a brightness acquisition section configured to acquire, for each of at least one of one or more recognition images included in a captured image obtained by imaging a predetermined area including an object of a circuit board by an imaging device, a brightness of at least one point located inside the recognition image; and
a target image determination section configured to determine whether the recognition image is a target image that is an image indicating the object based on a brightness of each of the at least one point acquired by the brightness acquisition section,
wherein it is determined whether a recognizer corresponding to the recognition image is the object based on a determination result by the target image determination section, and
the target image determination section determines, for each of the at least one recognition image, whether the recognition image is the target image based on a comparison result between a brightness of each of the at least one point and a brightness of an edge of the recognition image.
